# EUROPEAN PATENT APPLICATION

(11) **EP 4 462 482 A1**
(43) Date of publication of application: **13.11.2024**
(21) Application number: 24175191.6
(22) Date of filing: 10.05.2024
(51) Int. Cl.: H01L 25/075, H01L 33/62, H01L 33/48

(54) **LIGHT EMITTING APPARATUS**

(30) Priority: 12.05.2023 US 202363465938 P; 09.05.2024 US 202418659391
(71) Applicant: Seoul Viosys Co., Ltd., Ansan-si, Gyeonggi-do 15429 (KR)
(72) Inventor: JANG, Bo Ram I, 15429 Ansan-si (KR); CHOI, Jae Young, 15429 Ansan-si (KR)
(74) Representative: Stolmár & Partner Patentanwälte PartG mbB

(57) **Abstract**

A light emitting apparatus is disclosed. The light emitting apparatus includes: a plurality of circuits disposed on a base substrate; one or more light emitting sources in at least a circuit among the plurality of circuits; and a pad disposed under the base substrate and contacting one electrode and the other electrode of each of the plurality of circuits, wherein the pad includes: a first sub-pad contacting one electrode of a first circuit among the plurality of circuits, a third sub-pad contacting the other electrode of the first circuit, a second sub-pad contacting one electrode of a second circuit among the plurality of circuits, and a fourth sub-pad contacting the other electrode of the second circuit, and at least a region of one surface of the second sub-pad is disposed to face at least a region of one surface of the third sub-pad.

## Description

### [Technical Field]

The present disclosure relates to a light emitting apparatus and a light emitting module. More particularly, the present disclosure relates to a light emitting apparatus and a light emitting module including multi-circuits.

### [Background Art]

Light emitting devices, for example, light emitting diodes, are inorganic semiconductor devices that emit light through recombination of electrons and holes, and have recently been used in various fields, for example, display devices, vehicular lamps, general lighting, and the like. Since light emitting diodes have long lifespan, low power consumption, and fast response time, light emitting apparatuses including the light emitting diodes are expected to replace conventional light sources.

A light emitting diode package may include two or more light emitting diodes connected to each other in series, parallel or series-parallel connection, as requested by consumers.

As a result, a pad pattern realized in a typical package for multiple light emitting diodes requires the light emitting diodes to be arranged in series, parallel, or series-parallel connection configuration by separate wires on an upper or lower surface of a substrate of the package, thereby causing design difficulty and inefficient space utilization in consideration of a space in the package for the light emitting diodes.

### [Disclosure]

### [Technical Problem]

To solve the problems mentioned above, exemplary embodiments provide a light emitting apparatus and a light emitting module, more specifically a light emitting apparatus and a light emitting module including multi-circuits.

The problems to be solved by the present disclosure are not limited to the problems mentioned above, and other technical problems not mentioned will become apparent to a person having ordinary knowledge in the art from the following description.

Exemplary embodiments provide a light emitting apparatus including electrode patterns efficiently arranged to facilitate space utilization and a light emitting module including the same.

Exemplary embodiments provide a light emitting apparatus capable of protecting circuitry from an external environment and a light emitting module including the same.

Exemplary embodiments provide a light emitting apparatus that may be easily connected in series, parallel, or series-parallel through pads and a light emitting module including the same.

Exemplary embodiments provide a light emitting apparatus capable of reducing an operation temperature of circuits to improve reliability and a light emitting module including the same.

Exemplary embodiments provide a light emitting apparatus with improved lifetime and reliability and a light emitting module including the same.

Exemplary embodiments provide a light emitting apparatus capable of producing clear colors and a light emitting module including the same.

Exemplary embodiments provide a light emitting apparatus capable of expressing a wide range of colors and a light emitting module including the same.

Exemplary embodiments provide a light emitting apparatus providing various light profiles and a light emitting module including the same.

Exemplary embodiments provide a light emitting apparatus having high efficiency through increase in light extraction efficiency and a light emitting module including the same.

### [Technical Solution]

The present disclosure proposes a light emitting apparatus and a light emitting module. In particular, the light emitting apparatus and the light emitting module proposed by the present disclosure include multi-circuits, wherein the multi-circuits refer to a plurality of circuits.

In accordance with one aspect of the present disclosure, a light emitting apparatus may include: a base substrate; a plurality of circuits disposed on the base substrate; and a pad disposed under the base substrate and contacting one electrode and the other electrode of each of the plurality of circuits, wherein at least a circuit among the plurality of circuits includes one or more light emitting sources; the pad includes a first sub-pad contacting one electrode of a first circuit among the plurality of circuits, a third sub-pad contacting the other electrode of the first circuit, a second sub-pad contacting one electrode of a second circuit among the plurality of circuits, and a fourth sub-pad contacting the other electrode of the second circuit; and at least a region of one surface of the second sub-pad is disposed to face at least a region of one surface of the third sub-pad.

At least a region of one surface of the first sub-pad may be disposed to face at least a region of one surface of the third sub-pad, and at least a region of one surface of the second sub-pad may be disposed to face at least a region of one surface of the fourth sub-pad.

When the first circuit and the second circuit are connected in series, the third sub-pad connected to the other electrode of the first circuit may be connected to the second sub-pad connected to one electrode of the second circuit.

When the first circuit and the second circuit connected in series are connected in series to a third circuit among the plurality of circuits, a fifth sub-pad connected to one electrode of the third circuit may be connected to the fourth sub-pad or a sixth sub-pad connected to the other electrode of the third circuit may be connected to the third sub-pad.

When the first circuit and the second circuit connected in series are connected in parallel to the third circuit among the plurality of circuits, the fifth sub-pad connected to one electrode of the third circuit may be connected to the first sub-pad and the sixth sub-pad connected to the other electrode of the third circuit may be connected to the fourth sub-pad.

When the first circuit and the second circuit are connected in parallel, the first sub-pad may be connected to the second sub-pad and the third sub-pad may be connected to the fourth sub-pad.

When the first circuit and the second circuit connected in parallel are connected in series to the third circuit among the plurality of circuits, the fifth sub-pad connected to one electrode of the third circuit may be connected to the fourth sub-pad or the sixth sub-pad connected to the other electrode of the third circuit may be connected to the third sub-pad.

At least two sub-pads among the first to fourth sub-pads may include regions having different lengths. In addition, at least two sub-pads among the first to fourth sub-pads may include regions having the same length. Further, at least two sub-pads among the first to fourth sub-pads may have different areas. At least two sub-pads among the first to fourth sub-pads may not adjoin each other.

The light emitting source may include a first light emitting source and a second light emitting source, wherein the first light emitting source and the second light emitting source may emit light having different peak wavelengths. The first light emitting source and the second light emitting source may be connected to different circuits, respectively.

The light emitting apparatus may further include a wavelength converter disposed in at least a region of the light emitting source.

At least a circuit among the plurality of circuits may include a protection device.

At least a circuit among the plurality of circuits may include an integrated circuit (IC) device.

The light emitting apparatus may further include a reflector disposed in at least a region of the substrate, wherein the reflector may have a light reflectivity of 70% or more with respect to light emitted from the light emitting source.

The light emitting apparatus may further include a circuit protector covering at least a region of at least the circuit on the base substrate.

In accordance with another aspect of the present disclosure, a light emitting apparatus may include: a base substrate; a plurality of circuits disposed on the base substrate; and a pad disposed under the base substrate and contacting one electrode and the other electrode of each of the plurality of circuits, wherein at least a circuit among the plurality of circuits includes one or more light emitting sources; at least a circuit among the plurality of circuits includes at least an integrated circuit (IC) device; the pad includes a first sub-pad contacting one electrode of a first circuit among the plurality of circuits, a third sub-pad contacting the other electrode of the first circuit, a second sub-pad contacting one electrode of a second circuit among the plurality of circuits, and a fourth sub-pad contacting the other electrode of the second circuit; and at least a region of one surface of the second sub-pad is disposed to face at least a region of one surface of the third sub-pad.

At least a region of one surface of the first sub-pad may be disposed to face at least a region of one surface of the third sub-pad and at least a region of one surface of the second sub-pad may be disposed to face at least a region of one surface of the fourth sub-pad.

When the first circuit and the second circuit are connected in series, the third sub-pad connected to the other electrode of the first circuit may be connected to the second sub-pad connected to one electrode of the second circuit.

When the first circuit and the second circuit connected in series are connected in series to a third circuit among the plurality of circuits, a fifth sub-pad connected to one electrode of the third circuit may be connected to the fourth sub-pad or a sixth sub-pad connected to the other electrode of the third circuit may be connected to the third sub-pad.

When the first circuit and the second circuit connected in series are connected in parallel to the third circuit among the plurality of circuits, the fifth sub-pad connected to one electrode of the third circuit may be connected to the first sub-pad and the sixth sub-pad connected to the other electrode of the third circuit may be connected to the fourth sub-pad.

When the first circuit and the second circuit are connected in parallel, the first sub-pad may be connected to the second sub-pad and the third sub-pad may be connected to the fourth sub-pad.

When the first circuit and the second circuit connected in parallel are connected in series to the third circuit among the plurality of circuits, the fifth sub-pad connected to one electrode of the third circuit may be connected to the fourth sub-pad or the sixth sub-pad connected to the other electrode of the third circuit may be connected to the third sub-pad.

At least two sub-pads among the first to fourth sub-pads may include regions having different lengths. In addition, at least two sub-pads among the first to fourth sub-pads may include regions having the same length. Further, at least two sub-pads among the first to fourth sub-pads may have different areas. At least two sub-pads among the first to fourth sub-pads may not adjoin each other.

The light emitting source includes a first light emitting source and a second light emitting source, wherein the first light emitting source and the second light emitting source may emit light having different peak wavelengths. The first light emitting source and the second light emitting source may be connected to different circuits, respectively.

The integrated circuit device may individually operate the first light emitting source and the second light emitting source of the light emitting source.

The light emitting apparatus may further include a wavelength converter disposed in at least a region of the light emitting source.

At least a circuit among the plurality of circuits may include a protection device.

At least a circuit among the plurality of circuits may include an integrated circuit device.

The light emitting apparatus may further include a reflector disposed in at least a region of the substrate, wherein the reflector has a light reflectivity of 70% or more with respect to light emitted from the light emitting source.

The light emitting apparatus may further include a circuit protector covering at least a region of at least the circuit on the base substrate.

In accordance with a further aspect of the present disclosure, a light emitting apparatus may include: a base substrate; a plurality of circuits disposed on the base substrate; and a pad disposed under the base substrate and contacting one electrode and the other electrode of each of the plurality of circuits, wherein at least a circuit among the plurality of circuits includes one or more light emitting sources; the pad includes a first sub-pad contacting one electrode of a first circuit among the plurality of circuits, a third sub-pad contacting the other electrode of the first circuit, a second sub-pad contacting one electrode of a second circuit among the plurality of circuits, and a fourth sub-pad contacting the other electrode of the second circuit; and at least a region of one surface of the second sub-pad is disposed to face at least a region of one surface of the third sub-pad, the light emitting apparatus further including a wavelength converter converting at least one of dominant wavelengths of the one or more light emitting sources.

The plurality of circuits may include at least an integrated circuit (IC) device.

At least a region of one surface of the first sub-pad may be disposed to face at least a region of one surface of the third sub-pad and at least a region of one surface of the second sub-pad may be disposed to face at least a region of one surface of the fourth sub-pad.

When the first circuit and the second circuit are connected in series, the third sub-pad connected to the other electrode of the first circuit may be connected to the second sub-pad connected to one electrode of the second circuit.

When the first circuit and the second circuit connected in series are connected in series to a third circuit among the plurality of circuits, a fifth sub-pad connected to one electrode of the third circuit may be connected to the fourth sub-pad or a sixth sub-pad connected to the other electrode of the third circuit may be connected to the third sub-pad.

When the first circuit and the second circuit connected in series are connected in parallel to the third circuit among the plurality of circuits, the fifth sub-pad connected to one electrode of the third circuit may be connected to the first sub-pad and the sixth sub-pad connected to the other electrode of the third circuit may be connected to the fourth sub-pad.

When the first circuit and the second circuit are connected in parallel, the first sub-pad may be connected to the second sub-pad and the third sub-pad may be connected to the fourth sub-pad.

When the first circuit and the second circuit connected in parallel are connected in series to the third circuit among the plurality of circuits, the fifth sub-pad connected to one electrode of the third circuit may be connected to the fourth sub-pad or the sixth sub-pad connected to the other electrode of the third circuit may be connected to the third sub-pad.

At least two sub-pads among the first to fourth sub-pads may include regions having different lengths. In addition, at least two sub-pads among the first to fourth sub-pads pad may include regions having the same length. Further, at least two sub-pads among the first to fourth sub-pads may have different areas. At least two sub-pads among the first to fourth sub-pads may not adjoin each other.

The light emitting source includes a first light emitting source and a second light emitting source, wherein the first light emitting source and the second light emitting source may emit light having different peak wavelengths. The first light emitting source and the second light emitting source may be connected to different circuits, respectively.

The light emitting apparatus may further include a wavelength converter disposed in at least a region of the light emitting source.

At least a circuit among the plurality of circuits may include a protection device.

At least a circuit among the plurality of circuits may include an integrated circuit device.

The light emitting apparatus may further include a reflector disposed in at least a region of the substrate, wherein the reflector has a light reflectivity of 70% or more with respect to light emitted from the light emitting source.

The light emitting apparatus may further include a circuit protector covering at least a region of at least the circuit on the base substrate.

In accordance with yet another aspect of the present disclosure, a light emitting apparatus may include: a base substrate; a plurality of circuits disposed on the base substrate; and a pad disposed under the base substrate and contacting one electrode and the other electrode of each of the plurality of circuits, wherein at least a circuit among the plurality of circuits includes one or more light emitting sources; the pad includes a first sub-pad contacting one electrode of a first circuit among the plurality of circuits, a third sub-pad contacting the other electrode of the first circuit, a second sub-pad contacting one electrode of a second circuit among the plurality of circuits, and a fourth sub-pad contacting the other electrode of the second circuit; and at least a region of one surface of the second sub-pad is disposed to face at least a region of one surface of the third sub-pad, the light emitting apparatus further including a circuit protector protecting at least a region of the plurality of circuits. Here, the circuit protector may include a protection device protecting the plurality of circuits from overvoltage.

The plurality of circuits may include at least an integrated circuit (IC) device.

The light emitting apparatus may further include a wavelength converter converting at least one of dominant wavelengths of the one or more light emitting sources.

When the first circuit and the second circuit are connected in series, the third sub-pad connected to the other electrode of the first circuit may be connected to the second sub-pad connected to one electrode of the second circuit.

When the first circuit and the second circuit connected in series are connected in series to a third circuit among the plurality of circuits, a fifth sub-pad connected to one electrode of the third circuit may be connected to the fourth sub-pad or a sixth sub-pad connected to the other electrode of the third circuit may be connected to the third sub-pad.

When the first circuit and the second circuit connected in series are connected in parallel to the third circuit among the plurality of circuits, the fifth sub-pad connected to one electrode of the third circuit may be connected to the first sub-pad and the sixth sub-pad connected to the other electrode of the third circuit may be connected to the fourth sub-pad.

When the first circuit and the second circuit are connected in parallel, the first sub-pad may be connected to the second sub-pad and the third sub-pad may be connected to the fourth sub-pad.

When the first circuit and the second circuit connected in parallel are connected in series to the third circuit among the plurality of circuits, the fifth sub-pad connected to one electrode of the third circuit may be connected to the fourth sub-pad or the sixth sub-pad connected to the other electrode of the third circuit may be connected to the third sub-pad.

At least two sub-pads among the first to fourth sub-pads may include regions having different lengths. In addition, at least two sub-pads among the first to fourth sub-pads may include regions having the same length. Further, at least two sub-pads among the first to fourth sub-pads may have different areas. At least two sub-pads among the first to fourth sub-pads may not adjoin each other.

The light emitting source includes a first light emitting source and a second light emitting source, wherein the first light emitting source and the second light emitting source may emit light having different peak wavelengths. The first light emitting source and the second light emitting source may be connected to different circuits, respectively.

At least a circuit among the plurality of circuits may include a protection device.

At least a circuit among the plurality of circuits may include an integrated circuit device.

The light emitting apparatus may further include a reflector disposed in at least a region of the substrate, wherein the reflector has a light reflectivity of 70% or more with respect to light emitted from the light emitting source.

The light emitting apparatus may further include a circuit protector covering at least a region of at least the circuit on the base substrate.

In accordance with yet another aspect of the present disclosure, a light emitting apparatus may include: a base substrate; a plurality of circuits disposed on the base substrate; and a pad disposed under the base substrate and contacting one electrode and the other electrode of each of the plurality of circuits, wherein at least a circuit among the plurality of circuits includes one or more light emitting sources; the pad includes a first sub-pad contacting one electrode of a first circuit among the plurality of circuits, a third sub-pad contacting the other electrode of the first circuit, a second sub-pad contacting one electrode of a second circuit among the plurality of circuits, and a fourth sub-pad contacting the other electrode of the second circuit; and at least a region of one surface of the second sub-pad is disposed to face at least a region of one surface of the third sub-pad, the light emitting apparatus further including a reflector surrounding at least a region of the one or more light emitting source.

The plurality of circuits may include at least an integrated circuit (IC) device.

The light emitting apparatus may further include a wavelength converter converting at least one of dominant wavelengths of the one or more light emitting sources.

The light emitting apparatus may further include a circuit protector protecting at least a region of the plurality of circuits. Here, the circuit protector may include a protection device protecting the plurality of circuits from overvoltage.

When the first circuit and the second circuit are connected in series, the third sub-pad connected to the other electrode of the first circuit may be connected to the second sub-pad connected to one electrode of the second circuit.

When the first circuit and the second circuit connected in series are connected in series to a third circuit among the plurality of circuits, a fifth sub-pad connected to one electrode of the third circuit may be connected to the fourth sub-pad or a sixth sub-pad connected to the other electrode of the third circuit may be connected to the third sub-pad.

When the first circuit and the second circuit connected in series are connected in parallel to the third circuit among the plurality of circuits, the fifth sub-pad connected to one electrode of the third circuit may be connected to the first sub-pad and the sixth sub-pad connected to the other electrode of the third circuit may be connected to the fourth sub-pad.

When the first circuit and the second circuit are connected in parallel, the first sub-pad may be connected to the second sub-pad and the third sub-pad may be connected to the fourth sub-pad.

When the first circuit and the second circuit connected in parallel are connected in series to the third circuit among the plurality of circuits, the fifth sub-pad connected to one electrode of the third circuit may be connected to the fourth sub-pad or the sixth sub-pad connected to the other electrode of the third circuit may be connected to the third sub-pad.

At least two sub-pads among the first to fourth sub-pads may include regions having different lengths. In addition, at least two sub-pads among the first to fourth sub-pads may include regions having the same length. Further, at least two sub-pads among the first to fourth sub-pads may have different areas. At least two sub-pads among the first to fourth sub-pads may not adjoin each other.

The light emitting source includes a first light emitting source and a second light emitting source, wherein the first light emitting source and the second light emitting source may emit light having different peak wavelengths. The first light emitting source and the second light emitting source may be connected to different circuits, respectively.

The light emitting apparatus may further include a wavelength converter disposed in at least a region of the light emitting source.

The light emitting apparatus may further include a reflector disposed in at least a region of the substrate, wherein the reflector has a light reflectivity of 70% or more with respect to light emitted from the light emitting source.

The light emitting apparatus may further include a circuit protector covering at least a region of at least the circuit on the base substrate.

In accordance with yet another aspect of the present disclosure, a light emitting module includes one or more light emitting apparatuses, each of the one or more light emitting apparatuses including: a substrate including a base substrate; a plurality of circuits disposed on the base substrate; and a pad disposed under the base substrate and contacting one electrode and the other electrode of each of the plurality of circuits, wherein at least a circuit among the plurality of circuits includes one or more light emitting sources; the pad includes a first sub-pad contacting one electrode of a first circuit among the plurality of circuits, a third sub-pad contacting the other electrode of the first circuit, a second sub-pad contacting one electrode of a second circuit among the plurality of circuits, and a fourth sub-pad contacting the other electrode of the second circuit; and at least a region of one surface of the second sub-pad is disposed to face at least a region of one surface of the third sub-pad.

The light emitting module may include at least an integrated circuit (IC) device disposed in one region of the substrate.

The light emitting module may further include a circuit protector disposed in one region of the substrate and protecting at least a region of the plurality of circuits. The circuit protector may include a protection device protecting the plurality of circuits from overvoltage.

The light emitting module may include a solder pattern disposed in one region of the substrate and connecting at least two sub-pads included in the pad.

When the first circuit and the second circuit are connected in series, the second sub-pad may be connected to the third sub-pad through the solder pattern.

When the first circuit and the second circuit connected in series are connected in series to a third circuit among the plurality of circuits, a fifth sub-pad connected to one electrode of the third circuit may be connected to the fourth sub-pad through the solder pattern or a sixth sub-pad connected to the other electrode of the third circuit may be connected to the third sub-pad through the solder pattern.

When the first circuit and the second circuit are connected in parallel, the first sub-pad may be connected to the second sub-pad through the solder pattern and the third sub-pad may be connected to the fourth sub-pad through the solder pattern.

When the first circuit and the second circuit connected in parallel are connected in series to the third circuit among the plurality of circuits, a fifth sub-pad connected to one electrode of the third circuit may be connected to the fourth sub-pad through the solder pattern or a sixth sub-pad connected to the other electrode of the third circuit may be connected to the third sub-pad through the solder pattern.

At least two sub-pads among the first to fourth sub-pads may include regions having different lengths. In addition, at least two sub-pads among the first to fourth sub-pads may include regions having the same length. Further, at least two sub-pads among the first to fourth sub-pads may have different areas. At least two sub-pads among the first to fourth sub-pads may not adjoin each other.

The light emitting source includes a first light emitting source and a second light emitting source, wherein the first light emitting source and the second light emitting source may emit light having different peak wavelengths. The first light emitting source and the second light emitting source may be connected to different circuits, respectively.

The light emitting module may further include a wavelength converter disposed in at least a region of the light emitting source.

At least a circuit among the plurality of circuits may include a protection device.

The light emitting module may further include a reflector disposed in at least a region of the substrate, wherein the reflector has a light reflectivity of 70% or more with respect to light emitted from the light emitting source.

The light emitting module may further include a circuit protector covering at least a region of at least the circuit on the base substrate.

The above aspects of the present disclosure are only some of exemplary embodiments of the present disclosure and various embodiments reflecting technical features of the present disclosure may be derived and understood by a person having ordinary knowledge in the art from the following detailed description of the invention.

### [Advantageous Effects]

Embodiments of the present disclosure can more efficiently realize a series, parallel, or series-parallel configuration of multi-circuits to meet consumer needs through a pad pattern realized in a multi-circuit package.

Advantageous effects to be obtained from the present disclosure are not limited to those mentioned above and other effects not mentioned will be apparent to a person having ordinary knowledge in the art.

### [Description of Drawings]

FIG. 1 is exemplary views of a light emitting apparatus according to an embodiment of the present disclosure.
FIG. 2 is a top view of a light emitting apparatus according to an embodiment of the present disclosure.
FIG. 3 is a top view of a light emitting apparatus according to an embodiment of the present disclosure.
FIG. 4 is a top view of a light emitting apparatus according to an embodiment of the present disclosure.
FIG. 5 is a top view of a light emitting apparatus according to an embodiment of the present disclosure.
FIG. 6 is a conceptual view of a lower region of the base substrate of a light emitting apparatus according to an embodiment of the present disclosure.
FIG. 7 is a conceptual view of a lower region of the base substrate of a light emitting apparatus according to the embodiment of a present disclosure.
FIG. 8 is a diagram of a light emitting module including a light emitting apparatus according to an embodiment of the present disclosure.
FIG. 9 is a view of an example of a solder pattern on a module substrate of the light emitting module according to the embodiment of the present disclosure.
FIG. 10 is a view of another example of the solder pattern on the module substrate of the light emitting module according to the embodiment of the present disclosure.

### [Detailed Description]

The present disclosure may be variously modified and realized in many different forms, and thus specific embodiments will be exemplified in the drawings and described in detail herein below. However, in the the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or realized in another exemplary embodiment without departing from the inventive concepts.

Unless otherwise specified, the illustrated exemplary embodiments are to be understood as providing exemplary features of varying detail of some ways in which the inventive concepts may be realized in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is realized differently, a specific process order may be performed differently from the described order. For example, two consecutively described processes may be performed substantially at the same time or performed in an order opposite the described order. In addition, like reference numerals denote like elements.

When an element, for example, a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, for example, the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, for example, "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "includes," "including," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically realized by electronic (or optical) circuits, for example, logic circuits, discrete components, microprocessors, hard-wired circuits, memory elements, wiring connections, and the like, which may be formed using semiconductor-based fabrication techniques or other manufacturing technologies. In the case of the blocks, units, and/or modules being realized by microprocessors or other similar hardware, they may be programmed and controlled using software (for example, microcode) to perform various functions discussed herein and may optionally be driven by firmware and/or software. It is also contemplated that each block, unit, and/or module may be realized by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, for example, those defined in commonly used dictionaries, should be interpreted as having a meaning that is consistent with their meaning in the context of the relevant art and should not be interpreted in an idealized or overly formal sense, unless expressly so defined herein.

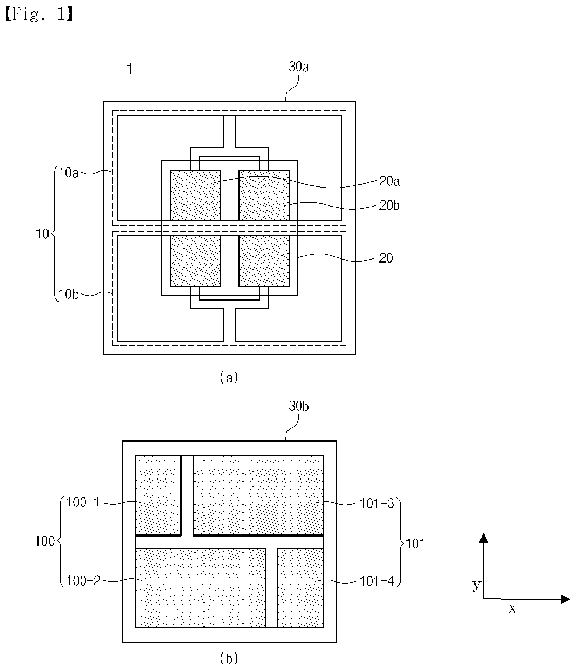

FIG. 1 illustrates a light emitting apparatus 1 according to an embodiment of the present disclosure.

The light emitting apparatus 1 according to the embodiment may include a base substrate, circuitry 10, and pads 100, 101. The base substrate includes an upper region 30a and a lower region 30b. The base substrate may be manufactured to have high thermal conductivity and high reflection efficiency (with a material having these properties). For example, the base substrate may be formed of aluminum nitride (AIN) ceramic or Al₂O₃ ceramic, plastics including a polymer, or the like. The base substrate may be formed of acrylonitrile butadiene styrene (ABS), a liquid crystalline polymer (LCP), polyamide (PA), polyphenylene sulfide (IPS), or a thermoplastic elastomer (TPE), and a metallic material. By way of example, the base substrate may have a thermal conductivity of about 170 W/mk. In addition, materials, such as Cu, Ag, Au, Al, and the like, may be added (for example, coated or deposited) on the base substrate to improve reflection efficiency. However, the materials for the base substrate are not limited thereto and may include various materials, such as GaAs, GaN, Si, Al, Cu, and/or sapphire. In addition, the base substrate may include a material having a minimum resistance of 2 x 10⁶ Ω cm or more.

The circuitry 10 may be electrical paths along which electricity or signals may be delivered. The circuitry 10 may be formed of a metal such as Cu, Ag, Ni, Al, Au, Fe, W, and the like, a metal oxide such as ITO (indium tin oxide), or a conductive material such as graphene, carbon nanotubes and the like, without being limited thereto. The circuitry 10 may have an electrical resistance of 100 Ω/cm or less. The circuitry 10 may include a plurality of circuits 10a, 10b and at least a circuit among the plurality of circuits 10a, 10b may include a light emitting source 20.

The light emitting source 20 may include at least a light emitting device. The light emitting device may generate and emit light through an active layer activated upon application of electric current. The light emitting device may include an LED chip. The LED chip may generate light having wavelengths in a particular region, such as ultraviolet light, blue light, green light, yellow light, red light, infrared light, or the like.

The pads 100, 101 may be electrically connected to the circuitry 10 to transmit an externally applied current, voltage, or electrical signal into the circuitry 10. The pads 100, 101 may be formed of metals having low electrical resistance such as Cu, Ag, Ni, Al, Au, Fe, W, and the like, compounds thereof, metal oxides such as ITO (indium tin oxide), or conductive materials such as graphene, carbon nanotubes, and the like, and may be formed of the same material as the circuitry 10, without being limited thereto.

FIG. 1(a) shows an upper region of the light emitting apparatus 1 according to the embodiment of the present disclosure and FIG. 1(b) shows a lower region of the light emitting apparatus 1 according to the embodiment of the present disclosure.

Referring to FIG. 1(a), the upper region 30a of the base substrate includes a circuit region and a non-circuit region, and the circuitry 10 is disposed in the circuit region of the upper region 30a of the base substrate. The circuit region may be provided in plural, and may be separated by the non-circuit region. The circuit region includes a conductive region and a non-conductive region, and may correspond to circuits of the circuitry 10. In the upper region 30a of the base substrate, the non-circuit region and the non-conductive region of the circuit region may include at least one material in common. The non-circuit region and the non-conductive region of the circuit region may be composed of the same material. The conductive region of the circuit region may include at least one different material than the non-circuit region. In the upper region 30a of the base substrate, the non-circuit region may surround at least a region of the circuit region. A region of the non-conductive regions of the circuit region may be connected to the non-circuit region. The circuit region and the non-circuit region of the upper region 30a of the base substrate may have different shapes or sizes. The circuit region and the non-circuit region may have different areas. In the circuit region of the upper region 30a of the base substrate, the conductive region and the non-conductive region may have different shapes or sizes. The circuit region of the upper region 30a of base substrate may include a plurality of conductive regions and one or more non-conductive regions may be disposed between adjacent conductive regions among the plurality of conductive regions. The circuit regions may be spaced apart from each other by the non-conductive regions. The upper region 30a of the base substrate may include a plurality of circuit regions.

The circuitry 10 may include a plurality of circuits 10a, 10b, in which at least a circuit may include a light emitting source 20. In FIG. 1(a), the circuitry 10 includes a first circuit 10a and a second circuit 10b. The first circuit 10a and the second circuit 10b may be spaced apart from each other to be electrically isolated from each other on the upper region 30a of the base substrate. At least one of the first circuit 10a and the second circuit 10b may include the light emitting source 20.

The light emitting source 20 is disposed on one circuit and may be disposed to include a region overlapping one region of each of the plurality of conductive regions and at least a non-conductive region in the circuit. The non-conductive region disposed in the overlapping region may divide the conductive regions to divide a flow of power or signals, and divided conductive region may guide electric current or signals to flow through the light emitting source 20 disposed between the conductive regions such that the light emitting source 20 can be operated. In addition, one circuit may include a plurality of light emitting sources 20. When a plurality of light emitting sources 20 is disposed in one circuit, the plurality of light emitting sources 20 may be electrically or signally connected in common to at least one conductive region. Connection of the plural light emitting sources 20 to a common conductive region can secure a larger heat dissipation area than direct connection of the plurality of light emitting sources 20 to each other, thereby reducing the operation temperature of the light emitting sources 20 while improving reliability.

Each of the circuits 10a, 10b may include at least a light emitting source 20. Referring to FIG. 1(a), each of the plurality of circuits includes two light emitting sources and the circuit regions of the first and second circuits are symmetrical, without being limited thereto. Alternatively, the plurality of circuits 10a, 10b of the circuitry 10 may include different numbers of light emitting sources and the circuit regions may have different sizes and shapes depending on the magnitude of electric current applied to the light emitting source 20 or the size of the light emitting source 20.

The light emitting source 20 may include a plurality of light emitting sources. In particular, referring to FIG. 1, the first circuit 10a may include a first light emitting source 20a and a second light emitting source 20b. Each of the first light emitting source 20a and the second light emitting source 20b may include a light emitting diode. The light emitting diodes of the first light emitting source 20a and the second light emitting source 20b may emit light in the same color gamut. Alternatively, the light emitting diodes of the first light emitting source 20a and the second light emitting source 20b may emit light having different peak wavelengths. By the first light emitting source 20a and the second light emitting source 20b, the light emitting apparatus 1 may have a wide color gamut. That is, the light emitting apparatus 1 can express a wide range of colors. Alternatively, the light emitting diodes of the first light emitting source 20a and the second light emitting source 20b may emit light having different dominant wavelengths. Alternatively, the light emitting diodes of the first light emitting source 20a and the second light emitting source 20b may emit light with a difference of 10 nm or less between a center wavelength and the dominant wavelength. With the first light emitting source 20a and the second light emitting source 20b, the light emitting apparatus 1 can realize vivid colors.

At least one of the first light emitting source 20a and the second light emitting source 20b may include a plurality of light emitting diodes. The plurality of light emitting diodes disposed in at least one of the first light emitting source 20a and the second light emitting source 20b may emit light in the same color gamut. Alternatively, the plurality of light emitting diodes may emit light having different peak wavelengths. Alternatively, the plurality of light emitting diodes may emit light having different dominant wavelengths. Alternatively, the plurality of light emitting diodes may emit light with a difference of 10 nm or less between the peak wavelength and the dominant wavelength.

The light emitting source 20 may include a light emitting diode and a wavelength converter. The wavelength converter may be disposed in an exit path of light emitted from the light emitting diode. The wavelength converter may be disposed to cover at least a region of the light emitting device. The wavelength converter may include at least one type of fine particles to convert a wavelength in a first wavelength band, which is the wavelength of light emitted from the light emitting device. The fine particles may include at least one of a first type of particles converting the wavelength in the first wavelength band to a wavelength in a second wavelength band and a second type of particle converting the wavelength in the first wavelength band to a wavelength in a third wavelength band. The wavelength in the first wavelength band may be shorter than the wavelength in the second wavelength band, and the wavelength in the third wavelength band may be longer than the wavelength in the second wavelength band. Further, the wavelength in the first wavelength band may be shorter than the wavelength in the second wavelength band and the wavelength in the third wavelength band may be longer than the wavelength in the second wavelength band. For example, the wavelength in the first wavelength band may be a wavelength in the blue wavelength band, the wavelength in the second wavelength band may be a wavelength in the yellow or green wavelength band, and the wavelength in the third wavelength band may be a wavelength in the red wavelength band.

The fine particles may include phosphor particles, quantum dots, or organic dyes. For example, the first type of particles may include wavelength-converting particles that emit light having a peak wavelength in the green or yellow wavelength band and may include at least one of quantum dots, LuAG particles, YAG particles, beta-SiAlON particles, nitride particles, silicate particles, halophosphide particles, or oxynitride particles, without being limited thereto. The second type of particles may include red wavelength-converting particles that emit light having a peak wavelength in the red wavelength band, and may include at least one of quantum dots, nitride particles, such as CASN, CASON, and SCASN, silicate particles, sulfide particles, or fluoride particles, without being limited thereto.

The wavelength converter may be a film or sheet type wavelength converter, such as PIS (phosphor in silicon), PIG (phosphor in glass), and PIC (phosphor in ceramic). The wavelength converter may include silicone resins, such as methyl silicone or phenyl silicone, and may include an organic material, such as a fluoropolymer, an epoxy resin, polyphthalamide (PPA), polybutylene terephthalate (PBT), polycarbonate (PC), and the like, glass, such as borosilicate, aluminosilicate, soda-lime glass, and the like, and a light-transmissive material, such as fused quartz and the like. The wavelength convertor may be formed of a material that transmits light, thereby increasing efficiency of extracting light to the outside of the light emitting apparatus 1.

A plurality of pads may be disposed on the lower region 30b of the base substrate. Referring to FIG. 1(b), a first pad 100 and a second pad 101 are disposed on the lower region 30b of the base substrate. The first pad 100 and the second pad 101 may have different electric polarities. Alternatively, the first pad 100 and the second pad 101 may have different functions. For example, the first pad 100 may have an electrical polarity and the second pad 101 may transfer data signals. In addition, each of the first pad 100 and the second pad 101 may include a plurality of sub-pads 100-1, 100-2, 101-3, 101-4. The first pad 100 and the second pad 101 may be electrically connected to one electrode and the other electrode of the circuitry 10 on the upper region 30a of the base substrate.

Referring to FIG. 1(b), the first pad 100 may be an anode pad and the second pad 101 may be a cathode pad. The first pad 100, which is the anode pad, may include a plurality of anode sub-pads, that is, a first sub-pad 100-1 and a second sub-pad 100-2, and the second pad 101, which is the cathode pad, may include a plurality of cathode pads, that is, a third sub-pad 101-3 and a fourth sub-pad 101-4. The plurality of sub-pads 100-1, 100-2, 101-3, 101-4 may be electrically connected to one electrode and the other electrode of each of the plurality of circuits 10 disposed on the upper region 30a of the base substrate. At least one light emitting source 20 disposed in at least a circuit may include one light emitting diode and may be configured as an independent circuit.

The anode sub-pads 100-1, 100-2 and the cathode sub-pads 101-3, 101-4 may pass through the base substrate such that leads corresponding to each pad are exposed on an upper surface of the base substrate and the cathodes and the anodes of the one or more light emitting devices are connected to the leads. For example, among the plurality of sub-pads 100-1, 100-2, 101-3, 101-4, the first sub-pad 100-1 may be electrically connected to one electrode of the first circuit 10a, the third sub-pad 101-3 may be electrically connected to the other electrode of the first circuit 10a, the second sub-pad 100-2 may be electrically connected to one electrode of the second circuit 10b, and the fourth sub-pad 101-4 may be electrically connected to the other electrode of the second circuit 10b.

At least two sub-pads among the plurality of sub-pads 100-1, 100-2, 101-3, 101-4 may have different areas. In addition, at least two sub-pads among the plurality of sub-pads 100-1, 100-2, 101-3, 101-4 may have substantially the same length on one surface thereof. Among the plurality of sub-pads, at least a region of one surface of the second sub-pad 100-2 may be disposed to face at least a region of one surface of the third sub-pad 101-3. Further, at least a region of one surface of the second sub-pad 100-2 may include a region that overlaps at least a region of one surface of the third sub-pad 101-3. In the embodiment of Fig. 1, an area of the first sub-pad 100-1 and the fourth sub-pad 101-4 is smaller than an area of the second sub-pad 100-2 and the third sub-pad 101-3. The first pad 100 and the second pad 101 are arranged one behind the other along a first direction (x). The first sub-pad 100-1 and the fourth sub-pad 101-4 have the same first length along the first direction, and the second sub-pad 100-2 and the third sub-pad 101-3 have the same second length along the first direction, the second length being larger than the first length. The first sub-pad 100-1 has a region facing the second sub-pad 100-2 and a region facing the third sub-pad 101-3. The second sub-pad 100-2 has a region facing the first sub-pad 100-1, a region facing the fourth sub-pad 101-4, and a region facing the third sub-pad 101-3. The third sub-pad 101-3 has a region facing the first sub-pad 100-1, a region facing the second sub-pad 100-2, and a region facing the fourth sub-pad 101-4. The fourth sub-pad 101-4 has a region facing the second sub-pad 100-2 and a region facing the third sub-pad 101-3. When seen in a second direction (y) perpendicular to the first direction (x), the second sub-pad 100-2 and the third sub-pad 101-3 partially overlap.

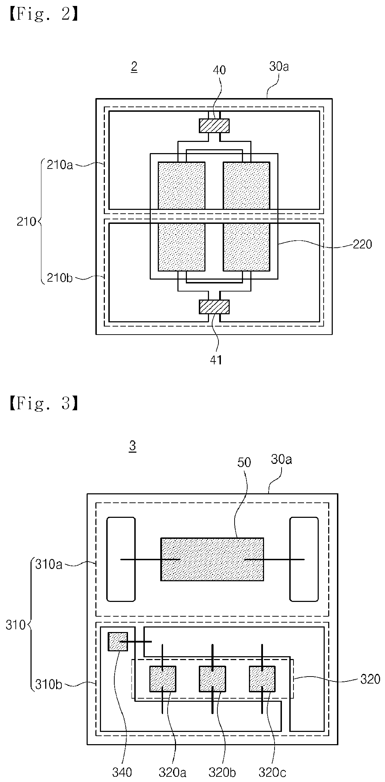

FIG. 2 is a top view of a light emitting apparatus 2 according to an embodiment of the present disclosure, in which the upper region 30a of the base substrate of FIG. 1 includes protection devices 40, 41. Further, FIG. 2 illustrates an example in which circuitry 210 includes a first circuit 210a and a second circuit 210b each including a light emitting source 220.

Referring to FIG. 2, at least a circuit of the circuitry 210 may include the protection devices 40, 41. Referring to FIG. 2, the first circuit 210a includes a first protection device 40 and the second circuit 210b includes a second protection device 41.

The protection devices 40, 41 may be electrically connected to one electrode and the other electrode of at least a circuit 210a and/or 210b. For example, the protection devices 40, 41 may be connected to an anode and a cathode of the light emitting source 220 included in the circuits 210a, 210b.

In addition, when the protection devices 40, 41 are unidirectional protection devices 40, 41, anodes of the protection devices 40, 41 may be electrically connected to cathodes of the circuitry 210, and cathodes of the protection devices 40, 41 may be electrically connected to anodes of the circuitry 210. For example, the anodes of the unidirectional protection devices 40, 41 may be electrically connected to the second pad 101, which is a cathode pad, and the cathodes of the unidirectional protection devices 40, 41 may be electrically connected to the first pad 100, which is an anode pad.

When each of the plurality of circuits 210a, 210b includes the unidirectional protection devices 40, 41, the anode of the first protection device 40 disposed in the first circuit is electrically connected to the third sub-pad 101-3, which is a cathode pad, and the cathode of the first protection device 40 is electrically connected to the first sub-pad 100-1, which is an anode pad. The anode of the second protection device 41 disposed in the second circuit may be electrically connected to the fourth sub-pad 101-4, which is a cathode pad, and the cathode of the second protection device 41 may be electrically connected to the third sub-pad 100-2, which is an anode pad.

When the protection devices 40, 41 are bidirectional protection devices, there is no difference in polarity between the protection devices 40, 41. Thus, one electrode of the protection devices 40, 41 is connected to one electrode of the circuitry 210 and the other electrode of the protection devices 40, 41 is connected to the other electrode of the circuitry 210. That is, one electrode of the protection devices 40, 41 may be electrically connected to the first pad 100 and the other electrode of the protection devices 40, 41 may be connected to the second pad 101.

As such, the protection devices 40, 41 are disposed in at least a circuit 210a and/or 210b of the circuitry 210, whereby the circuitry 210 can be prevented from being electrically damaged by surge current and static electricity, thereby improving lifespan and reliability of the light emitting apparatus.

The protection devices 40, 41 may be realized by devices, such as Zener diodes, silicon avalanche diodes, overvoltage suppressors, and the like, which serve to protect the circuitry 210 by regulating breakdown voltage of the devices to control sudden flow of electric current through regulation of the content of impurity in a PN junction or PNP junction.

FIG. 3 is a cross-sectional view of a light emitting apparatus 3 according to an embodiment of the present disclosure.

FIG. 3 illustrates an integrated circuit (IC) device 50 disposed on the upper region 30a of the base substrate shown in FIG. 1.

In this embodiment, a lower region of the base substrate may have the same configuration as that shown in FIG. 1(b).

Referring to FIG. 3, the integrated circuit device 50 may include a control device for regulating operation of components in at least a region of a plurality of circuits 310a, 310b. For example, when at least a circuit among the plurality of circuits 310a, 310b includes a plurality of light emitting sources 320, the integrated circuit device 50 may include a control device for regulating operation of at least a light emitting source 320a, 320b and/or 320c of the light emitting sources 320.

FIG. 3 illustrates a plurality of circuits 310, in which a first circuit 310a includes the integrated circuit device 50 and a second circuit 310b includes the light emitting source 320. In particular, the light emitting source 320 includes a first light emitting source 320a, a second light emitting source 320b, and a third light emitting source 320c.

The integrated circuit device 50 may include a power management integrated circuit, a dimming controller, a driver, and the like for regulating operation of light emitting diodes of the light emitting source 320. In addition, the integrated circuit device 50 may include a device, such as a digital signal processor (DSP) or a microcontroller (MCU). By way of example, the integrated circuit device 50 may adjust brightness of one or more light emitting diodes. Further, monochromatic light can be output or various colors can be expressed by mixing two or more light by controlling two or more light emitting diodes. Further, colors with various color coordinates between different color coordinates of two or more light emitting diodes can be expressed by controlling the two or more light emitting diodes emitting light with the different color coordinates.

When the integrated circuit device 50 is connected to the first circuit 310a, as shown in FIG. 3, one electrode of the integrated circuit device 50 may be connected to the first sub-pad 100-1 of the first circuit 310a and the other electrode of the integrated circuit device 50 may be connected to the third sub-pad 101-3. Here, at least one of the first sub-pad 100-1 or the third sub-pad 101-3 connected to the integrated circuit device 50 may be connected to an input voltage for electrical operation of the integrated circuit device 50, an output voltage, or the ground. Here, the input voltage may be an input signal controlling operation of the integrated circuit device 50 and the output voltage may be an output signal output from the integrated circuit device 50 to control operation of another circuit, that is, the second circuit 310b.

By way of example, when the integrated circuit device 50 regulating operation of the light emitting device is connected to the first circuit 310a on the upper region 30a of the base substrate and the plurality of light emitting sources 20a, 20b, 20c is connected to the second circuit 310b, the pads 100, 101 on the lower region 30b of the base substrate may be configured as follows.

The first sub-pad 100-1 may receive an input signal for control of the integrated circuit device 50 and the third sub-pad 101-3 may be connected to the ground or may receive an output voltage output through control of the integrated circuit device 50. In addition, the second sub-pad 100-2 may receive an input voltage for operation of the second circuit 310b and the fourth sub-pad 101-4 may receive an operation signal of the second circuit 310b. The plurality of light emitting sources 320a, 320b, 320c in the second circuit 310b may include light emitting devices, such as red, blue, green and white light emitting diodes.

By way of example, in the structure wherein a drive IC is disposed in the first circuit 310a and three light emitting sources 320 with different color coordinates are disposed in the second circuit 310b such that, for example, a red light emitting device is disposed in the first light emitting source 320a, a blue light emitting device is disposed in the second light emitting source 320b, and a green light emitting device is disposed in the third light emitting source 320c, the integrated circuit device 50 outputs an output voltage of the third sub-pad 101-3 when an input signal is input to the integrated circuit device 50 on the first sub-pad 100-1. Here, an input voltage of the second sub-pad 100-3 may be adjusted according to the output of the programmed integrated circuit device 50 to control operation of the light emitting source 320 in the second circuit 310b.

For example, the light emitting apparatus 3 outputs red light upon operation of the first light source 320a by a signal input to the integrated circuit 50integrated circuit device 50, outputs blue light upon operation of only the second light emitting source 320b, and outputs green light upon operation of only the third light emitting source 320c. In addition, the light emitting apparatus 3 outputs magenta light upon simultaneous operation of the first light emitting source 320a and the second light emitting source 320b by a specific signal, outputs yellow light upon simultaneous operation of the first light emitting source 320a and the third light emitting source 320c, and outputs cyan light upon simultaneous operation of the second light emitting source 320b and the third light emitting source 320c. Furthermore, when drive current of each of the first light emitting source 320a, the second light emitting source 320b, and the third light emitting source 320c is controlled, the light emitting apparatus may output various colors located between inherent color coordinates of each of at least two light emitting sources.

In addition, by way of example, two light emitting sources emitting white light having different color temperatures may be disposed in the light emitting source 320, in which the first light emitting source 320a emits white light having a color temperature of 1,800K to 4,000K and the second light emitting source 320b emits white light having a color temperature of 7,000K to 4,000K. Accordingly, the light emitting apparatus may output white light in color coordinates between 1,800K and 7,000K through output adjustment signal of the integrated circuit device 50.

In addition, not only when the light emitting sources 320a, 320b, 320c having different color coordinates are disposed, but also when two or more light emitting sources having the same color coordinate are disposed, the overall light intensity of the multi-circuit package can be adjusted through control of input and output signals of the integrated circuit device 50 and a light emission pattern with a narrow beam angle, a wide beam angle, or an intermediate beam angle can be realized through regulation of illumination zones of the light emitting sources 320, thereby providing various light profiles.

Referring to FIG. 3, the light emitting apparatus 3 may further include a protection device 340 in at least a circuit among the circuits 310a, 310b. The protection device 340 can prevent the circuits from being electrically damaged by surge current and static electricity, thereby improving lifespan and reliability of the light emitting apparatus.

As such, the integrated circuit device 50 may control operation of the components in the circuits 310 and protect the plurality of circuits 310 from problems, such as overvoltage, overcurrent, overheating, and the like, thereby improving reliability of the light emitting apparatus by preventing circuit damage caused by sudden changes in current or voltage.

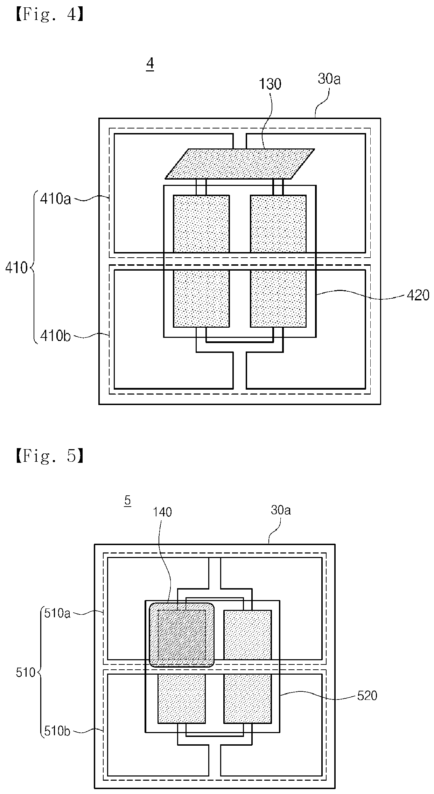

FIG. 4 is a cross-sectional view of a light emitting apparatus 4 according to an embodiment of the present disclosure. FIG. 4 shows a reflector 130 formed on the upper region 30a of the base substrate shown in FIG. 1. In this embodiment, a lower region of the base substrate may have the same configuration as that shown in FIG. 1(b).

Referring to FIG. 4, the light emitting apparatus 4 may include the reflector 130 for changing a traveling path of light emitted from the light emitting source 20. FIG. 4 shows that circuitry 410 of the light emitting apparatus 4 includes a first circuit 410a and a second circuit 410b, in which each of the first circuit 410a and the second circuit 410b includes a light emitting source 420.

The reflector 130 may adjust the beam angle of light upon emission of light from the reflector 130. The reflector 130 may have a light reflectivity of 70% or more with respect to light emitted from the light emitting source 20. Alternatively, the reflector 130 may have a light reflectivity of 90% or more with respect to light in the blue wavelength band of light emitted from the light emitting source 20, without being limited thereto. The reflector 130 may include a material having reflectivity with respect to light emitted from the light emitting source 20, and may include at least a metallic material having high light reflectivity, such as Al, Cu, Au, Ag, and the like. The reflector 130 may include at least one of polymeric organic compounds, such as silicone resins, epoxy resins, polymer resins, fluoropolymer resins, and the like. The reflector 130 may further include various additives to increase light reflectivity, such as TiO₂, Ba₂Ti₉O₂₀, BaSO₄, SiO₂, CaCOs, ZnO, CaCOs, and the like.

The reflector 130 may be disposed to adjoin at least a region of the upper region 30a of the base substrate. The reflector 130 may be disposed to adjoin at least a region of the circuit region on the upper region 30a of the base substrate. The reflector 130 may be disposed to overlap at least a region of the conductive region on the upper region 30a of the base substrate. The reflector 130 may be disposed to overlap at least a region of the non-conductive region on the upper region 30a of the base substrate. The reflector 130 may be disposed to cover at least a region of the conductive region and at least a region of the non-conductive region on the upper region 30a of the base substrate. The reflector 130 may be disposed to surround at least a region of the conductive region and at least a region of the non-conductive region on the upper region 30a of the base substrate.

The reflector 130 may be disposed to overlap at least a region of a side surface of the light emitting source 420. The reflector 130 may form a wall/hill that surrounds at least a region of the light emitting source 420. By way of example, the wall/hill formed by the reflector 130 may partially adjoin or be spaced apart from the side surface of the light emitting source 420. At least a region of the wall/hill formed by the reflector 130 may include at least an inclined region. The reflector surrounding at least a region of the light emitting source serves to adjust the beam angle of the light emitting apparatus 4 by changing the traveling path of light emitted from the light emitting source 420 in a certain direction and to reflect light directed around the light emitting source to travel in a forward direction, thereby preventing discoloration of the base substrate by light while improving luminous intensity and reliability of the light emitting apparatus 4.

The light emitting source 420 shown in FIG. 4 may be connected to the lower region 30b of the base substrate shown in FIG. 1(b) through the circuitry 410 and may have the same configuration as the light emitting source shown in FIG. 1.

Referring to FIG. 4, the light emitting apparatus 4 may further include protection devices 40, 41 in at least a circuit 410a and/or 410b among the plurality of circuits 410. When the light emitting apparatus 4 further includes the protection devices 40, 41, the protection devices 40, 41 may be electrically connected to one electrode and the other electrode of at least a circuit. For example, the protection devices 40, 41 may be connected to an anode and a cathode of the light emitting source 20. Further, when the protection devices 40, 41 are unidirectional protection devices 40, 41, anodes of the protection devices 40, 41 may be electrically connected to cathodes of the circuits and cathodes of the protection devices 40, 41 may be electrically connected to anodes of the circuits. For example, the anodes of the unidirectional protection device 40, 41 may be electrically connected to the second pad 101 and the cathodes of the unidirectional protection device 40, 41 may be electrically connected to the first pad 100. When each of the plurality of circuits includes the unidirectional protection devices 40, 41, the anode of the first protection device 40 disposed in the first circuit 410a may be electrically connected to the third sub-pad 101-3 and the cathode of the first protection device 40 may be electrically connected to the first sub-pad 100-1. The anode of the second protection device 41 disposed in the second circuit 410b may be electrically connected to the fourth sub-pad 101-4 and the cathode of the second protection device 41 may be electrically connected to the second sub-pad 100-2. When the protection devices 40, 41 are bidirectional protection devices, there is no difference in polarity between the protection devices 40, 41. Accordingly, one electrode of the protection devices 40, 41 is connected to one electrode of the circuits 410a, 410b and the other electrode of the protection devices 40, 41 is connected to the other electrode of the circuits 410a, 410b. That is, one electrode of the protection devices 40, 41 may be electrically connected to the first pad 100 and the other electrode of the protection devices 40, 41 may be connected to the second pad 101. By further including the protection devices 40, 41, the light emitting apparatus 4 can improve reliability by preventing damage to the circuitry 10 caused by sudden change in current or voltage.

Referring to FIG. 4, the light emitting apparatus 4 may further include an integrated circuit device 50 to regulate operation of at least some components or the entirety of the circuitry 410. When the light emitting apparatus 4 further includes the integrated circuit device 50, the integrated circuit device 50 may be covered by the reflector 130. When the integrated circuit device 50 is disposed below the reflector 130, the reflector 130 may reflect light emitted from the light emitting source 20 and directed to the integrated circuit, thereby improving light output efficiency while preventing the integrated circuit from being damaged by light energy converted into light or heat.

Here, operation and circuit connection of the integrated circuit may be the same as that shown in FIG. 3.

FIG. 5 is a cross-sectional view of a light emitting apparatus 5 according to an embodiment of the present disclosure. FIG. 5 shows a circuit protector 140 formed on the upper region 30a of base substrate shown in FIG. 1. In this embodiment, a lower region of base substrate may have the same configuration as that shown in FIG. 1(b). FIG. 5 shows the light emitting apparatus 5, in which circuitry 510 includes a first circuit 510a and a second circuit 510b and the circuits include a light emitting source 520.

Referring to FIG. 5, the light emitting apparatus 5 may include a circuit protector 140 for protecting the circuitry 510. The circuit protector 140 may be disposed in at least a region of the circuitry 510. The circuit protector 140 can protect at least a region of the circuitry 510 from an external environment, for example, pressure, temperature, humidity, dust, or the like.

The circuit protector 140 may be disposed overlap at least a region of a circuit region of the circuitry 510. Referring to FIG. 5, the circuit protector 140 overlaps at least a region of the first circuit 510a.

The circuit protector 140 may be disposed to overlap a conductive region of at least a region of the circuit region. The circuit protector 140 may be disposed to overlap a non-conductive region of at least a region of the circuit region. The circuit protector 140 may be disposed to overlap at least a region of the conductive region and at least a region of the non-conductive region in the circuit region. The circuit protector 140 may be disposed to cover at least a region of the light emitting source 20. The circuit protector 140 may be disposed to overlap at least a region of the conductive region and at least a region of the non-conductive region in the circuit region and at least a region of the light emitting source 520. Accordingly, the circuit protector 140 can protect one region of the circuit region or the entirety thereof from an external environment. When the circuit protector 140 is disposed only in one region of the circuit region, the circuit protector 140 may be disposed so as not to block a light emitting surface of the light emitting source 520 such that the light traveling path is not blocked, thereby preventing deterioration in light extraction efficiency, or the circuit protector 140 may be disposed to increase adhesion between a lower portion of the light emitting source 520 and an upper region of the base substrate, thereby preventing the devices of the light emitting source 520 from being detached or damaged by external pressure or impact. Here, the circuit protector may be formed of an under-fill material using a polymer resin, an epoxy resin, a silicone resin, a urethane rein, or the like, without being limited thereto. In addition, when the circuit protector is disposed in the conductive region of the circuitry, the circuit protector can prevent the conductive region from being oxidized by external moisture or from being corroded by sulfur or chlorine, thereby maintaining resistance of the circuitry.

When the circuit protector 140 is disposed to cover the upper surface of the light emitting source 520, the circuit protector 140 may extract light emitted from the light emitting source 520 and adjust the beam angle, and may be an encapsulation device that protects the light emitting source 520 or the conductive region of the circuit. The circuit protector 140 may include at least one of phenyl silicone, methyl silicone, epoxy, fused silica, borosilicate, soda-lime glass, aluminosilicate, fluoropolymer, polyphthalamide (PPA), polybutylene terephthalate (PBT), polycarbonate (PC), or EMC, all of which have light transmittance.

The circuit protector 140 may further include at least one of TiO₂, Ba₂Ti₉O₂₀, BaSO₄, SiO₂, CaCOs, ZnO, CaCOs, or the like, and can increase luminous efficacy by preventing light generated from the light emitting device from being absorbed by a certain region of the circuitry 10 or by improving reflectivity with respect to light generated from the light emitting device. The circuit protector 140 may also include a heat-conductive material, such as silicon, carbon C, carbon nanotubes, silver, copper, aluminum, diamond, or the like to facilitate heat dissipation from the light emitting apparatus 5.

Referring to FIG. 5, the light emitting apparatus 5 may further include a protection device 40, 41 in at least a circuit of the circuitry 510. The circuit protector 140 of the light emitting apparatus 5 may be disposed to cover at least a region of the protection devices 40, 41, in which the circuit protector 140 can prevent the protection devices 40, 41 from being damaged by an external environment. When the light emitting apparatus 5 further includes the protection devices 40, 41, connection and role of the protection devices 40, 41 may be similar to those described with reference to FIG. 2.

Referring to FIG. 5, the light emitting apparatus 5 may further include an integrated circuit device 50 for regulation of operation of at least some components or the entirety of the circuitry 510. The circuit protector 140 of the light emitting apparatus 5 may be disposed to cover at least a region of the integrated circuit device 50. The circuit protector 140 covering the region of the integrated circuit device 50 can protect the integrated circuit from the external environment, thereby improving reliability of the light emitting apparatus. In addition, heat generated upon operation of the integrated circuit device 50 may be dissipated through the circuit protector 140 to reduce damage to the integrated circuit device 50 caused by heat. Here, operation of the integrated circuit device 50 and connection of the circuitry 510 are the same as described above in FIG. 3.

Referring to FIG. 5, the light emitting apparatus 5 may further include a reflector 130. The reflector 130 may be disposed to overlap at least a region of the conductive region of the circuitry 10. The circuit protector 140 of the light emitting apparatus 5 may be disposed to overlap a region of the reflector 130 or the entire region thereof. By further including the reflective part 130, the light emitting apparatus 5 can prevent the reflector 130 from being damaged by corrosive gases in an external environment, thereby preventing deterioration in reflectivity.

Referring to FIG. 5, the light emitting apparatus 5 may further include the protection devices 40, 41, the integrated circuit device 50, and the reflector 130. The circuit protector 140 of the light emitting apparatus 5 may be disposed such that at least a region of the circuit protector 140 overlaps at least one of the protection devices 40, 41, the integrated circuit device 50, or the reflector 130. The circuit protector 140 of the light emitting apparatus 5 may be disposed such that at least a region of the circuit protector 140 overlaps at least two of the protection devices 40, 41, the integrated circuit device 50, or the reflector 130. The circuit protector 140 of the light emitting apparatus 5 may be disposed such that at least a region of the circuit protector 140 overlaps at least three of the protection devices 40, 41, the integrated circuit device 50, or the reflector 130. Accordingly, the circuit protector 140 can protect the protection devices 40, 41, the integrated circuits 50, and the reflector 130 from change in an environment outside the light emitting apparatus 5 while improving reliability of the entire light emitting apparatus 5 by increasing a moisture penetration path.

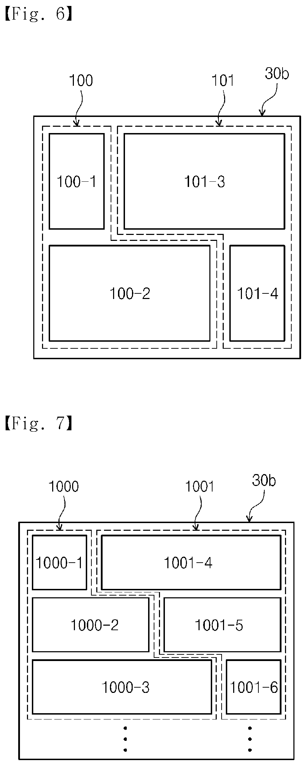

FIG. 6 is a conceptual diagram of a lower region 30b of the base substrate of a light emitting apparatus according to an embodiment of the present disclosure, which includes two circuits. For convenience of description, it is assumed that an upper region 30a of the base substrate of the light emitting apparatus according to this embodiment includes a first circuit 10a and a second circuit 10b, as shown in FIG. 1(a).

Referring to FIG. 6, the pads of the lower region 30b of the base substrate of the light emitting apparatus are shown. In particular, the pads of the lower region 30b of the base substrate are shown as including the first pad 100 and the second pad 101.

One electrode of the first circuit 10a may be electrically connected to the first sub-pad 100-1 of the first pad 100 and the other electrode of the first circuit 10a may be electrically connected to the third sub-pad 101-3 of the second pad 101.

One electrode of the second circuit 10b may be electrically connected to the second sub-pad 100-2 of the first pad 100 and the other electrode of the second circuit 10b may be electrically connected to the fourth sub-pad 101-4 of the second pad 101. One or the other electrode of the circuitry 10a, 10b may be connected to the corresponding sub-pads through conductive structures, such as leads or conductive via-holes formed on the base substrate.

The first to fourth sub-pads 100-1, 100-2, 101-3, 101-4 are spaced apart from each other and a non-conductive region is disposed in a separation region between adjacent sub-pads. The first to fourth sub-pads 100-1, 100-2, 101-3, 101-4 may be electrically isolated from each other and disposed on the lower region 30b. Thus, the first to fourth sub-pads 100-1, 100-2, 101-3, 101-4 may be disposed on the lower region 30b of the base substrate without any adjoining regions therebetween.

The first sub-pad 100-1 and the second sub-pad 100-2 may have different areas or sizes. The third sub-pad 101-3 and the fourth sub-pad 101-4 may have different areas or sizes. The first sub-pad 100-1 and the third sub-pad 101-3 may have different areas or sizes. The first sub-pad 100-1 and the fourth sub-pad 101-4 may have substantially the same area or size. The second sub-pad 100-2 and the third sub-pad 101-3 may have substantially the same area or size. The second sub-pad 100-2 and the fourth sub-pad 101-4 may have different areas or sizes. Thus, the plurality of sub-pads may be disposed in an electrically stable structure to be insulated from each other on the lower region of the base substrate having a limited area.

The first to fourth sub-pads 100-1, 100-2, 101-3, 101-4 may be disposed such that at least a region of one surface of a certain sub-pad overlaps at least a region of one surface of another sub-pad adjacent thereto. For example, at least a region of one surface of the third sub-pad 101-3 may be disposed to face at least a region of one surface of the second sub-pad 100-2. For example, the second sub-pad 100-2 may be disposed to face at least a region of one surface of each of the first sub-pad 100-1 and the third sub-pad 101-3.

With this configuration, series connection of the first circuit 10a and the second circuit 10b can be more easily realized through metal bonding between the second sub-pad 100-2 and the third sub-pad 101-3.

Further, at least a region of one surface of the first sub-pad 100-1 may be disposed to face at least a region of one surface of the second sub-pad 100-2 while being adjacent thereto and at least a region of one surface of the third sub-pad 101-3 may be disposed to face adjacent to at least a region of one surface of the fourth sub-pad 101-4 while being adjacent thereto.

With this configuration, parallel connection of the first circuit 10a and the second circuit 10b may be more easily realized through metal bonding between the first sub-pad 100-1 and the second sub-pad 100-2 and through metal bonding between the third sub-pad 101-3 and the fourth sub-pad 101-4. Metal bonding may be realized by intermetallic bonding or by solders or metal particle-containing adhesives, without being limited thereto.

By designing at least one of series connection, parallel connection or series-parallel connection on the lower region 30b of the base substrate rather than on the upper region 30a of the base substrate through electrical connection via metal bonding between the first pad 100 and the second pad 101, it is possible not only to omit a separate design process for connection between the circuits on the upper region 30a of the base substrate, but also to increase design flexibility through circuitry configuration as needed, while securing more efficient utilization of an interior space of the package to allow mounting of additional light emitting sources.

FIG. 7 is a conceptual diagram of a lower region 30b of the base substrate of a light emitting apparatus according to an embodiment of the present disclosure, which includes three circuits.

Referring to FIG. 7, the lower region 30b of the base substrate of the light emitting apparatus may include a first pad 1000 and a second pad 1001. As described above, the plurality of circuits may be disposed on the upper region 30a of the base substrate and the first pad 1000 and the second pad 1001 may be disposed on the lower region 30b of the base substrate. In addition, each of the plurality of circuits 10 may include one electrode and the other electrode. The circuitry 10 may include a first circuit, a second circuit, and a third circuit.

The first pad 100 may include a first sub-pad 1000-1 electrically connected to one electrode of the first circuit, a second sub-pad 1000-2 electrically connected to one electrode of the second circuit, and a third sub-pad 1000-3 electrically connected to one electrode of the third circuit.

In addition, the second pad 101 may include a fourth sub-pad 1001-4 electrically connected to the other electrode of the first circuit, a fifth sub-pad 1001-5 electrically connected to the other of the second circuit, and a sixth sub-pad 1001-6 electrically connected to the other electrode of the third circuit.

Preferably, at least a region of one surface of the second sub-pad 1000-2 is disposed to face at least a region of one surface of the fourth sub-pad 1001-4 and at least a region of one surface of the third sub-pad 1000-3 is disposed to face at least a region of one surface of the fifth sub-pad 1001-5. With this configuration, series connection of the first circuit, the second circuit, and the third circuit can be more easily realized through metal bonding between the second sub-pad 1000-2 and the fourth sub-pad 1001-4 and metal bonding between the third sub-pad 1000-3 and the fifth sub-pad 1001-5.

In addition, at least a region of one surface of the first sub-pad 1000-1 may be disposed to face at least a region of one surface of the second sub-pad 1000-2 and at least a region of one surface of the second sub-pad 1000-2 may be disposed to face at least a region of one surface of the third sub-pad 1000-3. In addition, at least a region of one surface of the fourth sub-pad 1001-4 may be disposed to face at least a region of one surface of the fifth sub-pad 1001-5 and at least a region of one surface of the fifth sub-pad 1001-5 may be disposed to face at least a region of one surface of the sixth sub-pad 1001-6. With this configuration, parallel connection of the first circuit, the second circuit, and the third circuit can be more easily realized through metal bonding between the first sub-pad 1000-1, the second sub-pad 1000-2 and the third sub-pad 1000-3, and through metal bonding between the fourth sub-pad 1001-4, the fifth sub-pad 1001-5 and the sixth sub-pad 1001-6.

By designing at least one of series connection, parallel connection, and series-parallel connection on the lower region of the base substrate rather than on the upper region of the base substrate through electrical connection via metal bonding between the first pad 1000 and the second pad 1001, it is possible not only to omit a separate design process on the upper region of the base substrate, but also to secure more efficient utilization of an interior space of the package to allow mounting of additional light emitting sources.

Although three circuits are illustrated in FIG. 7, it should be understood that other implementations are possible and that the number of sub-pads constituting the first pad 1000 and the number of sub-pads constituting the second pad 1001 may increase in proportion to the number of circuits.

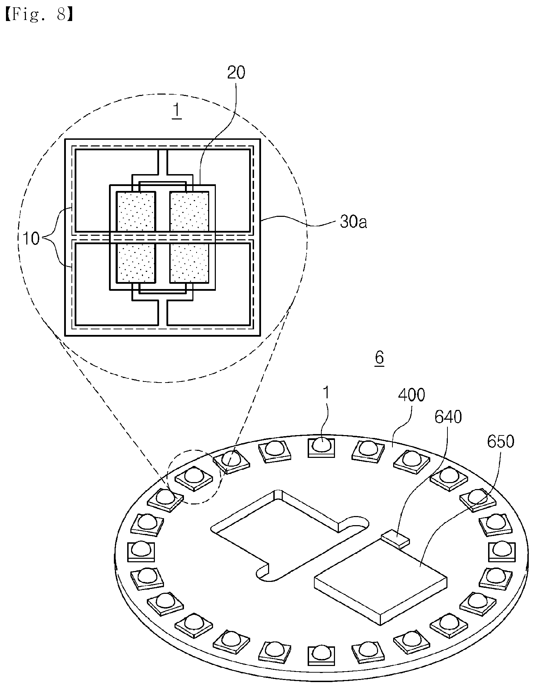

FIG. 8 is a diagram of a light emitting module 6 including a light emitting apparatus according to an embodiment of the present disclosure.

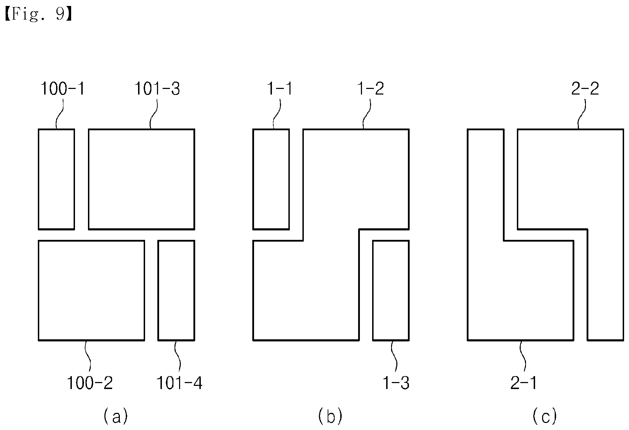

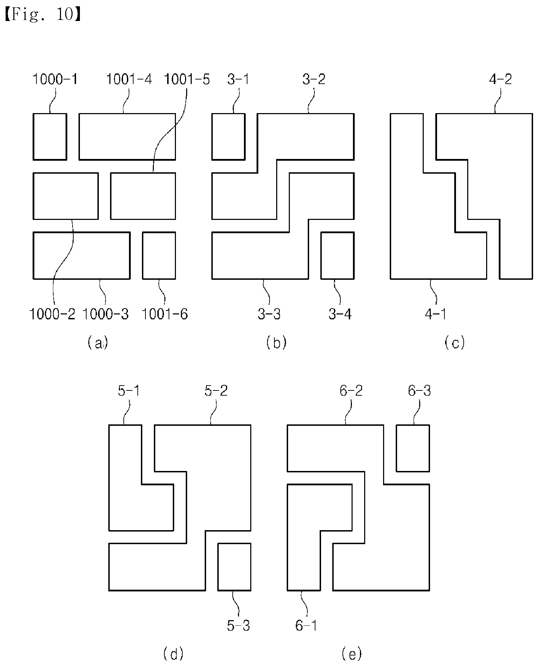

Referring to FIG. 8, the light emitting module 6 includes a module substrate 400 and a plurality of light emitting apparatuses 1 spaced apart from each other on one surface of the module substrate. Each of the light emitting apparatuses 1 may include a plurality of circuits 10 disposed on an upper region 30a of the base substrate and a plurality of pads 100, 101 disposed on a lower region 30b of the base substrate. The circuitry 10 may include two or more circuits, in which at least a circuit may include a light emitting source 20. The plurality of pads may include a first pad 100 and a second pad 101. The plurality of circuits may be electrically connected to the first pad 100 and the second pad 101 through solder pads (not shown) on the module substrate 400 and may be connected to each other in series, parallel, or series-parallel. The configuration of the solder pads will be described below with reference to FIG. 9 and FIG. 10.

The module substrate 400 may be provided on one surface thereof with a protection device 640, an integrated circuit 650, and at least one of a reflector 130 or a circuit protection device 140.

The module substrate 400 may be a printed circuit board (PCB) on which circuits are printed to allow the above devices to be disposed thereon and powered. The module substrate 400 may be formed of aluminum, copper, ceramics, or the like to facilitate heat dissipation and may be formed of paper board, epoxy, glass, or the like to increase structural flexibility. The integrated circuit 650 disposed on the module substrate may regulate operation of at least a light emitting apparatus 1 of the plurality of light emitting apparatuses disposed on the module substrate to improve light uniformity by controlling brightness uniformly. In addition, the integrated circuit 650 may regulate operation of the light emitting apparatus 1 having two or more different color coordinates to express a color temperature between two or more color coordinates. Further, the integrated circuit device 50 may stably regulate power applied to the circuits within the light emitting apparatus 1 to protect the circuits by preventing overcurrent or overvoltage from being applied to the circuitry 10.

The protection device 640 disposed on the module substrate 400 serves to protect the light emitting apparatus 1 or the integrated circuit 650 from surge current or ESD (electrostatic discharge), and may include a Zener diode, TVS, and the like.

The reflectors 130 may be disposed to overlap each other on at least one surface of the module substrate. Alternatively, the reflector 130 may be disposed to overlap at least a light emitting apparatus among the plurality of light emitting apparatuses 1 on the module substrate 400. Alternatively, the reflector 130 may be disposed between adjacent light emitting apparatuses 1 on the module substrate 400. The reflector 130 disposed on the module substrate 400 may change the traveling path of light emitted from the light emitting apparatus 1 or may adjust the beam angle. The reflector 130 may cover at least one surface of the integrated circuit650 or the protection device 640 to improve light extraction efficiency through reduction of light absorption.

FIG. 9 illustrates an example of a solder pad disposed the module substrate 400 of the light emitting module 6 according to the embodiment of the present disclosure.

In particular, FIG. 9 assumes that the light emitting apparatus 1 mounted on the module substrate 400 includes two circuits and FIG. 9(a) illustrates a pad configuration of the light emitting apparatus 1. The pad configuration illustrated in FIG. 9(a) and features thereof are the same as those described with reference to FIG. 6.

One surface of the module substrate 400 may include a conductive region and a non-conductive region. The conductive region of the module substrate 400 may include a solder pad. The solder pad of the module substrate may include a plurality of solder patterns corresponding to the circuit configuration of the light emitting apparatus mounted on the module substrate 400.

Referring to FIG. 9, two circuits included in the light emitting apparatus 1 may be connected to each other in series or in parallel depending on the solder pad formed on the module substrate 400.

When two circuits of the light emitting apparatus are connected in series, the solder pad of the module substrate 400 includes a first-1 solder pattern 1-1, a first-2 solder pattern 1-2, and a first-3 solder pattern 1-3, as shown in FIG. 9(b).

The first-1 solder pattern 1-1 is connected to the first sub-pad 100-1 of the light emitting apparatus through metal bonding, the first-2 solder pattern 1-2 is connected to the second sub-pad 100-2 and the third sub-pad 101-3 of the light emitting apparatus through metal bonding, and the first-3 solder pattern 1-3 is connected to the fourth sub-pad 101-4 of the light emitting apparatus through metal bonding. That is, the two circuits are connected in series through the first-2 solder pattern 1-2.

Since such circuit configuration allows connection through a lower portion of the light emitting apparatus, an interconnection region can be shortened to reduce interference between the circuits and circuit connection through jumpers or vias can be omitted to reduce difficulty in circuit configuration.

On the other hand, when two circuits included in the light emitting apparatus are connected in parallel, the solder pad of the module substrate 400 includes a second-1 solder pattern 2-1 and a second-2 solder pattern 2-2, as shown in FIG. 9(b). The second-1 solder pattern 2-1 is connected to the first sub-pad 100-1 and the second sub-pad 100-2 of the light emitting apparatus through metal bonding and the second-2 solder pattern 2-2 is connected to the third sub-pad 101-3 and the fourth sub-pad 101-4 of the light emitting apparatus through metal bonding. Since such circuit configuration allows connection through a lower portion of the light emitting apparatus, an interconnection region can be shortened and a metal bonding area can be increased to facilitate heat dissipation.

FIG. 10 illustrates another example of the solder pad on the module substrate 400 of the light emitting module 6 according to the embodiment of the present disclosure. In particular, FIG. 10 assumes that the light emitting apparatus 1 mounted on the module board includes three circuits, and FIG. 10(a) illustrates a pad configuration of the light emitting apparatus 1. The pad configuration illustrated in FIG. 10(a) and features thereof are the same as those described with reference to FIG. 7.

As shown in FIG. 9, a region of the module substrate 400 shown in FIG. 10 may include a conductive region and a non-conductive region. The conductive region of the module substrate may include a solder pad. The solder pad of the module substrate may include a plurality of solder patterns corresponding to the circuit configuration of the light emitting apparatus mounted on the module substrate.

Referring to FIG. 10, three circuits included in the light emitting apparatus may be connected in series, parallel, or series-parallel.

Specifically, when three circuits of the light emitting apparatus are connected in series, the solder pad of the module substrate 400 includes a third-1 solder pattern 3-1, a third-2 solder pattern 3-2, a third-3 solder pattern 3-3, and a third-4 solder pattern 3-4, as shown in FIG. 10(b).

The third-1 solder pattern 3-1 is connected to the first sub-pad 1000-1 of the light emitting apparatus through metal bonding, the third-2 solder pattern 3-2 is connected to the second sub-pad 1000-2 and the fourth sub-pad 1001-4 of the light emitting apparatus through metal bonding, the third-3 solder pattern 3-3 is connected to the third sub-pad 1000-3 and the fifth sub-pad 1001-5 through metal bonding, and the third-4 solder pattern 3-4 is connected to the sixth sub-pad 1001-6 through metal bonding. That is, the first circuit and the second circuit are connected in series through the third-2 solder pattern 3-2, and the second circuit and the third circuit are connected in series through the third-3 solder pattern 3-3. Since such circuit configuration allows connection through a lower portion of the light emitting apparatus, an interconnection region can be shortened to reduce interference between the circuits and circuit connection through jumpers or vias can be omitted to reduce difficulty in circuit configuration.

Alternatively, when three circuits included in the light emitting apparatus are connected in parallel, the solder pad of the module substrate 400 includes a fourth-1 solder pattern 4-1 and a fourth-2 solder pattern 4-2, as shown in FIG. 10(c). The fourth-1 solder pattern 4-1 is connected to the first sub-pad 1000-1, the second sub-pad 1000-2, and the third sub-pad 1000-3 of the light emitting apparatus through metal bonding, and the fourth-2 solder pattern 4-4 is connected to the fourth sub-pad 1001-4, the fifth sub-pad 1001-5, and the sixth sub-pad 1001-6 through metal bonding.

When two circuits included in the light emitting apparatus are connected in parallel and one circuit is connected in series, the solder pad of the module substrate 400 includes a fifth-1 solder pattern 5-1, a fifth-2 solder pattern 5-2, and a fifth-3 solder pattern 5-3, as shown in FIG. 10(d). The fifth-1 solder pattern 5-1 is connected to the first sub-pad 1000-1 and the second sub-pad 1000-2 of the light emitting apparatus through metal bonding, the fifth-2 solder pattern 5-2 is connected to the third sub-pad 1000-3, the fourth sub-pad 1001-4 and the fifth sub-pad 1001-5 through metal bonding, and the fifth-3 solder pattern 5-3 is connected to the sixth sub-pad 1001-6 through metal bonding.

In addition, as shown in FIG. 10(e), in series-parallel configuration using the solder pad including a sixth-1 solder pattern 6-1, a sixth-2 solder pattern 6-2, and a sixth-3 solder pattern 6-3, the sixth-1 solder pattern 6-1 is connected to the second sub-pad 1000-2 and the third sub-pad 1000-3 through metal bonding, the sixth-2 solder pattern 6-2 is connected to the first sub-pad 1000-1, the fifth sub-pad 1001-5, and the sixth sub-pad 1001-6 through metal bonding, and the sixth-3 solder pattern 6-3 is connected to the fourth sub-pad 1001-4 through metal bonding. The circuit configuration using such a solder pad enables complex circuit connection to be realized in a small region while facilitating various circuit configurations through change of only the module pattern design, as needed.

According to embodiments of the present disclosure, the distance between light emitting devices can be reduced as much as possible, thereby improving uniformity of light emitted from the plurality of light emitting devices.

The detailed description of preferred embodiments of the present disclosure disclosed above has been provided to allow those skilled in the art to implement and practice the present disclosure. Although some embodiments have been described herein, it should be understood by those skilled in the art that various modifications, variations and alterations can be made without departing from the scope of the disclosure. For example, those skilled in the art may utilize each of the configurations described in the above embodiments in combination with each other.

Therefore, it should be understood that the present disclosure is not intended to be limited to the embodiments herein, but rather to provide the broadest scope consistent with principles and novel features disclosed herein.

### [List of Reference Numerals]

1, 2, 3, 4, 5: Light emitting apparatus
6: Light emitting module
10, 210, 310, 410, 510: Circuit board
10a, 210a, 310a, 410a, 510a: First circuit
10b, 210b, 310b, 410b, 510b: Second circuit
20, 220, 320, 420, 520: Light emitting source
20a: First light emitting source
20b: Second light emitting source
100, 1000: First pad
101, 1001: Second pad
100-N, 101-N, 1000-N, 1001-N: N^{th} sub-pad
30a: Upper region of the base substrate
30b: Lower region of the base substrate
400: Module Board
50, 650: Integrated circuit
40, 41, 340, 640: Protection device
130: Reflector
140: Circuit Protector

## Claims

1. A light emitting apparatus comprising:
a base substrate;
a plurality of circuits disposed on the base substrate; and
a pad disposed under the base substrate and contacting one electrode and the other electrode of each of the plurality of circuits,
wherein at least a circuit among the plurality of circuits comprises one or more light emitting sources;
the pad includes a first sub-pad contacting one electrode of a first circuit among the plurality of circuits, a third sub-pad contacting the other electrode of the first circuit, a second sub-pad contacting one electrode of a second circuit among the plurality of circuits, and a fourth sub-pad contacting the other electrode of the second circuit; and
at least a region of one surface of the second sub-pad is disposed to face at least a region of one surface of the third sub-pad.

2. The light emitting apparatus according to claim 1, wherein at least a region of one surface of the first sub-pad is disposed to face at least a region of one surface of the third sub-pad, and at least a region of one surface of the second sub-pad is disposed to face at least a region of one surface of the fourth sub-pad.

3. The light emitting apparatus according to claim 1 or 2, wherein at least two sub-pads among the first to fourth sub-pads comprise regions having different lengths.

4. The light emitting apparatus according to any of claims 1 to 3, wherein at least two sub-pads among the first to fourth sub-pads comprise regions having the same length.

5. The light emitting apparatus according to claim 4, wherein at least two sub-pads among the first to fourth sub-pads do not adjoin each other in the regions having the same length.

6. The light emitting apparatus according to any of claims 1 to 5, further comprising:
a wavelength converter disposed in at least a region of the light emitting source.

7. The light emitting apparatus according to any of claims 1 to 6, wherein at least a circuit among the plurality of circuits comprises at least an integrated circuit (IC) device.

8. The light emitting apparatus according to any of claims 1 to 7, wherein the light emitting sources includes at least two light emitting devices, and each of light emitting device has a different wavelength.

9. The light emitting apparatus according to any of claims 1 to 8, wherein the base substrate has a plurality of circuit regions and a non-circuit region,
wherein the plurality of circuit regions are separated by the non-circuit region.

10. The light emitting apparatus according to claim 9, wherein the non-circuit region has a higher electric resistance than the plurality of circuit regions.

11. The light emitting apparatus according to any of claims 1 to 10, further comprising:
a solder pattern disposed on a substrate, and electrically connected to at least two sub-pads among the first to fourth sub-pads, and connecting said two sub-pads to each other.

12. The light emitting apparatus according to claim 11, wherein, when the first circuit and the second circuit are electrically connected in parallel, the first sub-pad is connected to the second sub-pad through the solder pattern.

13. The light emitting apparatus according to claim 12, wherein, the first sub-pad and the second sub-pad is electrically connected to the anode, and the third sub-pad and the forth sub-pad electrically connected to the cathode.

14. The light emitting apparatus according to claim 11, wherein, when the first circuit and the second circuit are electrically connected in series, the second sub-pad is connected to the third sub-pad through the solder pattern.

15. The light emitting apparatus according to claim 14, wherein the first sub-pad electrically connected to the anode, and the forth sub-pad electrically connected to the cathode.
